# EUROPEAN PATENT APPLICATION

(11) **EP 4 836 648 A1**
(43) Date of publication of application: **04.11.2026**
(21) Application number: 24914826.3
(22) Date of filing: 15.08.2024
(51) Int. Cl.: H10K 30/15, H10K 30/50

(54) **PEROVSKITE BATTERY, LAMINATED SOLAR CELL, PHOTOVOLTAIC MODULE, PHOTOVOLTAIC POWER GENERATION SYSTEM AND ELECTRICAL DEVICE**

(30) Priority: 02.01.2024 CN 202410008007
(71) Applicant: Contemporary Amperex Technology Co., Limited, Ningde, Fujian 352100 (CN)
(72) Inventor: CHEN, Changsong, Ningde, Fujian 352100 (CN); MA, Junfu, Ningde, Fujian 352100 (CN); LIU, Xiao, Ningde, Fujian 352100 (CN); LIANG, Weifeng, Ningde, Fujian 352100 (CN); SHI, Ruoxuan, Ningde, Fujian 352100 (CN); XIE, Qiaowen, Ningde, Fujian 352100 (CN); SU, Shuojian, Ningde, Fujian 352100 (CN); GUO, Yongsheng, Ningde, Fujian 352100 (CN)
(74) Representative: Gong, Jinping
(86) International application number: PCT/CN2024/112538
(87) International publication number: WO 2025/145604

(57) **Abstract**

A perovskite battery, a laminated solar cell, a photovoltaic module, a photovoltaic power generation system and an electric device, belonging to the technical field of photovoltaics. The perovskite battery comprises a perovskite light absorption layer and an electron transport layer comprising at least two transport sub-layers. The material of the transport sub-layers comprises metal oxide MₓO_{y}, M representing a metal element. The ratio of the number of metal atoms to the number of oxygen atoms in the transport sub-layers is x/y, and in the direction from the perovskite light absorption layer to the electron transport layer, the value of x/y of the transport sub-layers successively increases. Regulating the ratio of the number of metal atoms to the number of oxygen atoms of the metal oxide in the multi transport sub-layers of the perovskite battery can successively decrease the energy level structure in the electron transport layer in the direction from the perovskite light absorption layer to the electron transport layer, improve the transport capability of carriers in the electron transport layer, and increase the current of the perovskite battery, allowing the perovskite battery to have relatively high photoelectric energy conversion efficiency.

## Description

### CROSS-REFERENCE TO RELATED APPLICATIONS

The present application claims priority to Chinese Patent Application No. 202410008007.1, filed on January 02, 2024 and entitled "PEROVSKITE BATTERY, TANDEM SOLAR CELL, PHOTOVOLTAIC MODULE, PHOTOVOLTAIC POWER GENERATION SYSTEM, AND ELECTRIC DEVICE", which is incorporated herein by reference in its entirety.

### TECHNICAL FIELD

The present application relates to the field of photovoltaic technologies, and in particular, to a perovskite battery, a tandem solar cell, a photovoltaic module, a photovoltaic power generation system, and an electric device.

### BACKGROUND

Perovskite batteries have attracted widespread attention due to numerous advantages such as good optical absorption coefficient, luminescence quantum efficiency, high defect tolerance, long-range charge transport, and low-cost manufacturing process, and have strong application potential.

Current perovskite batteries have a relatively low photoelectric energy conversion efficiency, which seriously hinders the industrialization path of perovskite batteries.

### SUMMARY

In view of the deficiencies of the prior art, the present application provides a perovskite battery, a tandem solar cell, a photovoltaic module, a photovoltaic power generation system, and an electric device to improve the photoelectric energy conversion efficiency of the perovskite battery.

According to a first aspect, the present application provides a perovskite battery, where the perovskite battery includes a perovskite light-absorbing layer and an electron transport layer, and the electron transport layer includes at least two transport sub-layers; the material of the transport sub-layer includes a metal oxide MₓO_{y}, M representing a metal element; and an atomic ratio of metal atoms to oxygen atoms in the transport sub-layer is x/y, and along a direction from the perovskite light-absorbing layer to the electron transport layer, the values of x/y of the transport sub-layers increase sequentially.

In the perovskite battery provided by the present application, the electron transport layer has at least two transport sub-layers. The present application regulates a ratio of the number of metal atoms to the number of oxygen atoms in the metal oxide in the multi-layer transport sub-layers, and sets, along the direction from the perovskite light-absorbing layer to the electron transport layer, the ratio of the number of metal atoms to the number of oxygen atoms in the metal oxide in the transport sub-layers to increase sequentially, which can regulate an energy level structure in the electron transport layer, such that along the direction from the perovskite light-absorbing layer to the electron transport layer, an energy level structure in the electron transport layer decreases sequentially, improving the carrier transport capability in the electron transport layer, thereby increasing the current of the perovskite battery, resulting in a relatively high photoelectric energy conversion efficiency for the perovskite battery.

In some embodiments, along the direction from the perovskite light-absorbing layer to the electron transport layer, a thickness ratio of at least two transport sub-layers is (2 to 5):1. This allows for a relatively high carrier transport capability in the electron transport layer, resulting in a relatively high photoelectric energy conversion efficiency for the perovskite battery.

In some embodiments, along the direction from the perovskite light-absorbing layer to the electron transport layer, thicknesses of at least two transport sub-layers are 13 nm to 30 nm and 5 nm to 15 nm, respectively. This allows for a relatively high carrier transport capability in the electron transport layer, resulting in a relatively high photoelectric energy conversion efficiency for the perovskite battery.

In some embodiments, y:x ≤ 0.5 × z, where z is the highest valence oxidation state of M.

In some embodiments, 0.4 × z ≤ y:x ≤ 0.5 × z. When the ratio of the number of metal atoms to the number of oxygen atoms in the metal oxide in the transport sub-layer satisfies the above range, it is conducive to fully collecting electrons or holes generated by photon absorption in the perovskite light-absorbing layer under illumination, thereby further improving the carrier transport capability in the electron transport layer, further enhancing the energy level matching between the electron transport layer and the perovskite light-absorbing layer, and reducing the optical loss of the electron transport layer.

In some embodiments, when y:x in one transport sub-layer is 0.5 × z, the thickness proportion of the transport sub-layer where y:x is 0.5 × z in the electron transport layer is less than or equal to 75%. When the ratio of the number of metal atoms to the number of oxygen atoms in the metal oxide in one of the transport sub-layers is 1:(0.5 × z) (where z is the highest valence oxidation state of the metal element), regulating the thickness proportion of the transport sub-layer in the entire electron transport layer is conducive to further improving the carrier transport capability in the electron transport layer, thereby increasing the current of the perovskite battery, resulting in a relatively high photoelectric energy conversion efficiency for the perovskite battery.

In some embodiments, the metal element in the metal oxide includes at least one of Sn, Ti, Zn, W, Nb, In, Zr, Ce, Cr, Ba, Sr, Fe, and Li. The metal element in the metal oxide is selected from the above elements, which can effectively block the migration of ions, facilitating avoiding film degradation or deterioration caused by ion migration in the perovskite battery, and facilitating prolonging the service life of the perovskite battery.

In some embodiments, the metal element in the metal oxide includes at least one of Zn, Ti, and Sn.

In some embodiments, along the direction from the perovskite light-absorbing layer to the electron transport layer, energy levels of the transport sub-layers decrease sequentially. The above arrangement can improve the carrier transport capability in the electron transport layer, thereby increasing the current of the perovskite battery, resulting in a relatively high photoelectric energy conversion efficiency for the perovskite battery.

In some embodiments, an energy level difference between two adjacent transport sub-layers is less than or equal to 0.2 eV. When the energy level difference between two adjacent transport sub-layers is within the above range, it is conducive to improving the carrier extraction efficiency, thereby improving the photoelectric energy conversion efficiency of the perovskite battery.

In some embodiments, an intermediate layer is disposed between the perovskite light-absorbing layer and the electron transport layer; and the material of the intermediate layer includes a conductive material containing a carbon element. The arrangement of the intermediate layer can passivate defects on a surface of the perovskite light-absorbing layer, improve the interface energy level matching degree between the perovskite light-absorbing layer and the electron transport layer in the perovskite battery (especially the inverted-structure perovskite battery), which is conducive to avoiding the hysteresis effect in the perovskite battery, improving the carrier transport capability, and improving the photoelectric energy conversion efficiency of the perovskite battery.

In some embodiments, the material of the intermediate layer includes at least one of fullerene and a derivative thereof, an imide compound, a quinone compound, a pyrrolidone compound, an isoindigo compound, an indigo compound, a benzobisthiadiazole compound, a hexaazanaphthalenes compound, an indenothiophene compound, a tetraphenylethylene compound, and a conjugated polymer. The material of the intermediate layer includes the above substances, which is conducive to avoiding the hysteresis effect in the perovskite battery, thereby improving the photoelectric energy conversion efficiency of the perovskite battery.

In some embodiments, an energy level M₁ of the intermediate layer is less than an energy level M₂ of the transport sub-layer adjacent to the intermediate layer, and M₂ - M₁ ≤ 0.2 eV. This can improve the interface energy level matching degree between the perovskite light-absorbing layer and the electron transport layer in the perovskite battery (especially the inverted-structure perovskite battery), which is conducive to avoiding the hysteresis effect in the perovskite battery, improving the carrier transport capability, and improving the photoelectric energy conversion efficiency of the perovskite battery.

In some embodiments, a thickness ratio of the intermediate layer to the electron transport layer is (0.01 to 50):1, resulting in a relatively high photoelectric energy conversion efficiency for the perovskite battery.

In some embodiments, the thickness ratio of the intermediate layer to the electron transport layer is (1 to 3):1, which can fully exert the advantages of the intermediate layer and the electron transport layer, facilitating further improving the photoelectric energy conversion efficiency of the perovskite battery.

In some embodiments, the perovskite battery includes a transparent substrate layer, a hole transport layer, the perovskite light-absorbing layer, the intermediate layer, the electron transport layer, and an electrode layer sequentially provided; or, the perovskite battery includes a transparent substrate layer, the electron transport layer, the intermediate layer, the perovskite light-absorbing layer, a hole transport layer, and an electrode layer sequentially provided. In the inverted-structure or regular-structure perovskite battery, the interface energy level matching degree between the perovskite light-absorbing layer and the electron transport layer is high, which can improve the photoelectric energy conversion efficiency of the inverted-structure or regular-structure perovskite battery.

According to a second aspect, the present application provides a tandem solar cell, where the tandem solar cell includes the perovskite battery according to any one of the first aspect.

According to a third aspect, the present application provides a photovoltaic module, where the photovoltaic module includes the perovskite battery according to any one of the above first aspect or the tandem solar cell according to the above second aspect.

According to a fourth aspect, the present application provides a photovoltaic power generation system, where the photovoltaic power generation system includes a plurality of electrically connected photovoltaic modules according to the above third aspect.

According to a fifth aspect, the present application provides an electric device, where the electric device includes a plurality of electrically connected photovoltaic power generation systems according to the above fourth aspect.

The foregoing descriptions are merely an overview of the technical solution of the present application. For a better understanding of the technical means in the present application such that they can be implemented according to the content of the specification, and to make the above and other objectives, features and advantages of the present application more obvious and easier to understand, the following describes specific embodiments of the present application.

### BRIEF DESCRIPTION OF DRAWINGS

To describe the technical solutions in embodiments of the present application more clearly, the following briefly describes the accompanying drawings required for describing some embodiments. It is appreciated that the accompanying drawings below show merely some embodiments of the present application and thus should not be considered as limitations on the scope. Persons of ordinary skill in the art may still derive other related drawings from the accompanying drawings without creative efforts.
FIG. 1 is a schematic structural diagram of a first perovskite battery according to some embodiments of the present application;
FIG. 2 is a schematic structural diagram of a second perovskite battery according to some embodiments of the present application; and
FIG. 3 is a schematic structural diagram of a photovoltaic module according to some embodiments of the present application.

### Reference signs:

1000 - photovoltaic module;
1100 - battery string; 1200 - front glass; 1300 - front encapsulation film; 1400 - back encapsulation film; 1500 - back glass;
100 - perovskite battery;
110 - transparent substrate layer; 120 - hole transport layer; 130 - perovskite light-absorbing layer; 140 - intermediate layer; 150 - electron transport layer; 151 - transport sub-layer; and 160 - electrode layer.

### DESCRIPTION OF EMBODIMENTS

The following describes in detail some embodiments of technical solutions of the present application with reference to the accompanying drawings. The following embodiments are merely intended for a clearer description of the technical solutions of the present application and therefore are merely used as examples which do not constitute any limitation on the protection scope of the present application.

Unless otherwise defined, all technical and scientific terms used herein shall have the same meanings as commonly understood by persons skilled in the art to which the present application relates. The terms used herein are intended to merely describe the specific embodiments rather than to limit the present application. The terms "include", "comprise", and "have" and any other variations thereof in the specification, claims and brief description of drawings of the present application are intended to cover non-exclusive inclusions.

In the descriptions of the embodiments of the present application, the technical terms "first", "second", and the like are merely intended to distinguish between different objects, and shall not be understood as any indication or implication of relative importance or any implicit indication of the number, specific sequence, or primary-secondary relationship of the technical features indicated. In the description of embodiments of the present application, "a plurality of" means at least two unless otherwise specifically stated.

In this specification, reference to "embodiment" means that specific features, structures, or characteristics described with reference to the embodiment may be included in at least one embodiment of the present application. The word "embodiment" appearing in various positions in the specification does not necessarily refer to the same embodiment or an independent or alternative embodiment that is exclusive of other embodiments. It is explicitly or implicitly understood by persons skilled in the art the embodiments described herein may be combined with other embodiments.

In the description of some embodiments of the present application, the term "and/or" is only an associative relationship for describing associated objects, indicating that three relationships may be present. For example, A and/or B may indicate the following three cases: presence of only A, presence of both A and B, and presence of only B. In addition, a character "/" in this specification generally indicates an "or" relationship between contextually associated objects.

In the descriptions of the embodiments of the present application, the term "a plurality of" means more than two (inclusive). Similarly, "a plurality of groups" means more than two (inclusive) groups, and " a plurality of pieces" means more than two (inclusive) pieces.

In the description of the embodiments of the present application, the orientations or positional relationships indicated by the technical terms "center", "longitudinal", "transverse", "length", "width", "thickness", "upper", "lower", "front", "rear", "left", "right", "vertical", "horizontal", "top", "bottom", "inside", "outside", "clockwise", "counterclockwise", "axial", " radial", "circumferential", and the like are based on the orientations or positional relationships as shown in the accompanying drawings. These terms are merely for ease and brevity of description of the embodiments of the present application rather than indicating or implying that the means or components mentioned must have specific orientations or must be constructed or manipulated according to specific orientations, and therefore shall not be construed as any limitation on the embodiments of the present application.

In the description of the embodiments of the present application, unless otherwise specified and defined explicitly, the technical terms "mounting", "connection", "join", and "fastening" should be understood in their general senses. For example, they may refer to a fixed connection, a detachable connection, or an integral connection, may refer to a mechanical connection or electrical connection, and may refer to a direct connection, an indirect connection via an intermediate medium, an internal communication between two elements, or an interaction between two elements.

As green energy batteries, currently, from the perspective of market development, application of solar cells is being more extensive. Solar cells are not only applied to photovoltaic power generation systems such as solar power stations, but also gradually applied to electric devices such as electric vehicles. With the continuous expansion of the application fields of solar cells, market demands for solar cells are also increasing.

Due to numerous advantages such as good optical absorption coefficient, luminescence quantum efficiency, high defect tolerance, long-range charge transport, and low-cost manufacturing process, perovskite batteries have become solar cells that have been widely researched and applied in recent years.

A perovskite battery generally includes functional layers such as a transparent substrate layer, a hole transport layer, a perovskite light-absorbing layer, an electron transport layer, and an electrode layer. The perovskite light-absorbing layer is mainly composed of perovskite material. When receiving sunlight irradiation, the perovskite light-absorbing layer first absorbs photons to generate electron□hole pairs (excitons). Under the action of the p□n junction electric field, the excitons are first separated into electrons and holes and transported to the cathode and anode respectively. The photogenerated holes flow to the p-region, the photogenerated electrons flow to the n-region, and when the circuit is connected, a current is formed.

However, current perovskite batteries have a relatively low photoelectric energy conversion efficiency, which seriously hinders the industrialization path of perovskite batteries. The inventors have found through research that the reason for the relatively low photoelectric energy conversion efficiency of perovskite batteries is that the carrier transport in the electron transport layer is blocked, and the carrier transport capability in the electron transport layer is relatively low, resulting in low current of the perovskite battery, thereby affecting the photoelectric energy conversion efficiency of the perovskite battery.

Based on the above considerations, in order to improve the photoelectric energy conversion efficiency of the perovskite battery, the present application designs a perovskite battery, where the perovskite battery includes a perovskite light-absorbing layer and an electron transport layer, and the electron transport layer includes at least two transport sub-layers; the material of the transport sub-layer includes a metal oxide MₓO_{y}, M representing a metal element; and an atomic ratio of metal atoms to oxygen atoms in the transport sub-layer is x/y, and along a direction from the perovskite light-absorbing layer to the electron transport layer, the values of x/y of the transport sub-layers increase sequentially.

In the perovskite battery provided by the present application, the electron transport layer has at least two transport sub-layers. The present application regulates a ratio of the number of metal atoms to the number of oxygen atoms in the metal oxide in the multi-layer transport sub-layers, and sets, along the direction from the perovskite light-absorbing layer to the electron transport layer, the ratio of the number of metal atoms to the number of oxygen atoms in the metal oxide in the transport sub-layers to increase sequentially, which can regulate an energy level structure in the electron transport layer, such that along the direction from the perovskite light-absorbing layer to the electron transport layer, the energy level structure in the electron transport layer decreases sequentially, improving the carrier transport capability in the electron transport layer, thereby increasing the current of the perovskite battery, resulting in a relatively high photoelectric energy conversion efficiency for the perovskite battery.

Hereinafter, the technical solutions of the present application are exemplarily described with reference to embodiments.

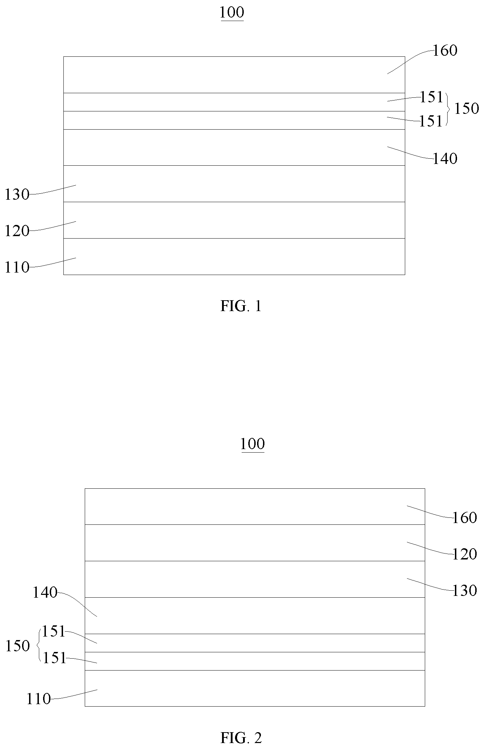

Referring to FIG. 1 and FIG. 2, the present application provides a perovskite battery 100, where the perovskite battery 100 includes a perovskite light-absorbing layer 130 and an electron transport layer 150, and the electron transport layer 150 includes at least two transport sub-layers 151; the material of the transport sub-layer 151 includes a metal oxide; and along a direction from the perovskite light-absorbing layer 130 to the electron transport layer 150, a ratio of the number of metal atoms to the number of oxygen atoms in the metal oxide in the transport sub-layer 151 increases sequentially.

The perovskite battery 100 is a perovskite solar cell, and generally includes functional layers such as a transparent substrate layer 110, a hole transport layer 120, a perovskite light-absorbing layer 130, an electron transport layer 150, and an electrode layer 160.

The perovskite battery 100 provided in the embodiments of the present application may be a regular-structure perovskite battery 100 or an inverted-structure perovskite battery 100, both of which can improve the device efficiency (that is, photoelectric energy conversion efficiency) and commercial value of the corresponding perovskite battery 100.

Referring to FIG. 1, in the inverted-structure perovskite battery 100, the transparent substrate layer 110, the hole transport layer 120, the perovskite light-absorbing layer 130, the electron transport layer 150, and the electrode layer 160 are sequentially provided. Referring to FIG. 2, in the regular-structure perovskite battery 100, the transparent substrate layer 110, the electron transport layer 150, the perovskite light-absorbing layer 130, the hole transport layer 120, and the electrode layer 160 are sequentially provided.

In the perovskite battery 100 provided in the embodiments of the present application, except for the improvement of the electron transport layer 150, the specifications and material types of other functional layers can be selected or designed as needed.

The transparent substrate layer 110 serves as an electrode with high conductivity and high visible light transmittance, and is one output terminal of the perovskite battery 100. The type of the transparent substrate layer 110 includes, for example but not limited to, FTO (fluorine-doped SnO₂ transparent conductive glass), ITO (indium tin oxide transparent conductive glass), AZO (aluminum-doped zinc oxide transparent conductive glass), BZO (benzodiazole transparent conductive glass), or IZO (indium zinc oxide transparent conductive glass).

The hole transport layer 120, as an important component of the perovskite battery 100, mainly functions to collect and transport holes, achieving effective separation of electrons and holes, and protecting the perovskite light-absorbing layer 130 from erosion by oxygen and moisture, thereby significantly impacting the efficiency and stability of the perovskite battery 100. A hole transport material in the hole transport layer 120 includes, for example, at least one of the following materials, derivatives thereof, and materials obtained by doping or passivation thereof: poly[bis(4-phenyl)(2,4,6-trimethylphenyl)amine] (PTAA), poly(3-hexylthiophene), tritylene-nucleated triphenylamine (H101), 3,4-ethylenedioxythiophene-methoxytriphenylamine (EDOT-OMeTPA), N-(4-anilino)carbazole-spirobifluorene (CzPAF-SBF), poly(3,4-ethylenedioxythiophene):poly(styrene sulfonic acid) (PEDOT:PSS), polythiophene, nickel oxide (NiOₓ), molybdenum oxide (MoO₃), cuprous iodide (CuI), cuprous oxide (CuO), 2,2',7,7'□tetrakis(N,N□di-p-methoxyphenylamino)□9,9'□spirobifluorene, methoxytriphenylamine□formamidine fluoride, poly(3,4□ethylenedioxythiophene), polystyrene sulfonic acid, tritylene-nucleated triphenylamine, phosphoric acid-based monolayer molecules, carboxylic acid-based monolayer molecules, carbazole-based monolayer molecules, sulfonic acid-based monolayer molecules, triphenylamine-based monolayer molecules, aromatic-based monolayer molecules, metal oxides, and copper thiocyanate. The metal element in the metal oxide selected in the hole transport material includes at least one of Ni, Mo, and Cu.

For example, a thickness of the hole transport layer 120 is, for example, 5 nm □ 500 nm, and optionally 10 nm □ 20 nm.

The perovskite light-absorbing layer 130 is the core component of the perovskite battery 100, and is used to absorb photon energy of sunlight, generate electron□hole pairs, and separate the electron□hole pairs into free electrons and holes under the action of the built-in electric field. The holes are collected by the transparent electrode through the hole transport layer 120, the electrons are collected by the electrode layer 160, and the transparent electrode and the electrode layer 160 are connected into a circuit to generate photocurrent.

The chemical formula of the perovskite material in the perovskite light-absorbing layer 130 satisfies ABX₃, where A is an inorganic, organic, or organic-inorganic hybrid cation; B is an inorganic, organic, or organic-inorganic hybrid cation; and X is an inorganic, organic, or organic-inorganic hybrid anion. A is selected from at least one of CH₃NH₃⁺ (MA⁺ for short), CH(NH₂)²⁺ (FA⁺ for short), Li⁺, Na⁺, K⁺, Rb⁺, and Cs⁺; and optionally, M is selected from at least one of CH₃NH₃⁺, CH(NH₂)²⁺, and Cs⁺. B is selected from at least one of Pb²⁺, Sn²⁺, Be²⁺, Mg²⁺, Ca²⁺, Sr²⁺, Ba²⁺, Zn²⁺, Ge²⁺, Fe²⁺, Co²⁺, and Ni²⁺; and optionally, B is selected from one or both of Pb²⁺ and Sn²⁺. X is selected from at least one of Cl⁻, Br⁻, and I⁻; and optionally, X is selected from at least one of Cl⁻, Br⁻, and I⁻.

For example, the perovskite material includes but is not limited to at least one of CH₃NH₃PbI₃ (MAPbI₃ for short), CH(NH₂)₂PbI₃ (FAPbI₃ for short), Cs_{0.05}(FA_{0.83}MA_{0.17})_{0.95}Pb(I_{0.83}Br_{0.17})₃ (CsFAMA for short), CsPbI₃, CsPbI₂Br, or CsPbIBr₂.

For example, a bandgap of the perovskite light-absorbing layer 130 is between 1.20 eV and 2.30 eV. The bandgap measurement method includes, for example: obtaining an ultraviolet absorption curve through ultraviolet absorption spectroscopy test, and then calculating the perovskite bandgap through the Tauc equation. The thickness of the perovskite light-absorbing layer 130 is between 100 nm and 1000 nm, for example but not limited to any one point value of 100 nm, 200 nm, 300 nm, 400 nm, 500 nm, 600 nm, 700 nm, 800 nm, 900 nm, and 1000 nm, or a value within a range defined by any two thereof. The thickness of the perovskite light-absorbing layer 130 refers to the dimension of the perovskite light-absorbing layer 130 in a thickness direction of the perovskite battery 100, and the thickness direction of the perovskite battery 100 also refers to the direction in which the functional layers are sequentially stacked.

The electrode layer 160 serves as another output terminal of the perovskite battery 100. The electrode layer 160 is an organic, inorganic, or organic-inorganic hybrid conductive material, and the conductive material is at least one of an organic conductive material and an inorganic conductive material. The organic conductive material may be a conductive polymer, and the conductive polymer includes but is not limited to at least one of poly(3,4-ethylenedioxythiophene) (PEDOT), polythiophene, or polyacetylene. The inorganic conductive material includes but is not limited to at least one of transparent conductive oxides, metals, or carbon derivatives. The inorganic conductive material is specifically, for example, Ag, Cu, C, Au, Al, ITO, AZO, BZO, and IZO.

For example, a thickness of the electrode layer 160 is, for example, 10 nm to 1000 nm.

The electron transport layer 150 is used to collect electrons or holes generated by photon absorption in the perovskite light-absorbing layer 130 under illumination, and has functions in transporting electrons and blocking electron-hole recombination. The electron transport layer 150 plays an important role in the perovskite battery 100, and its performance directly affects the performance of the battery.

In the present application, the electron transport layer 150 includes at least two transport sub-layers 151; the material of the transport sub-layer 151 includes a metal oxide MₓO_{y}, M representing a metal element; and an atomic ratio of metal atoms to oxygen atoms in the transport sub-layer is x/y, and along a direction from the perovskite light-absorbing layer to the electron transport layer, the values of x/y of the transport sub-layers increase sequentially.

"O" in "MₓO_{y}" is the oxygen element, and "x" and "y" in "MₓO_{y}" represent the number of metal atoms and the number of oxygen atoms in the metal oxide, respectively.

"Along a direction from the perovskite light-absorbing layer 130 to the electron transport layer 150, the values of x/y of the transport sub-layer 151 increase sequentially" means: the "ratio x/y of the number of metal atoms to the number of oxygen atoms in the metal oxide" in all transport sub-layers 151 are different from each other, and along the direction from the perovskite light-absorbing layer 130 to the electron transport layer 150, the " values of x/y" corresponding to the transport sub-layers 151 increase sequentially.

The present application does not limit the number of transport sub-layers 151 in the electron transport layer 150, and the number thereof may be 2, 3, or more.

It should be noted that the atomic ratio of metal atoms to oxygen atoms in each transport sub-layer 151 in the electron transport layer 150 is x/y and may be analyzed and determined by time-of-flight secondary ion mass spectrometry (TOF-SIMS).

The present application regulates the ratio of the number of metal atoms to the number of oxygen atoms in the metal oxide in the transport sub-layer 151 possessed in the electron transport layer 150, and sets, along the direction from the perovskite light-absorbing layer 130 to the electron transport layer 150, the ratio of the number of metal atoms to the number of oxygen atoms in the metal oxide in the transport sub-layer 151 to increase sequentially, which can regulate an energy level structure in the electron transport layer 150, such that along the direction from the perovskite light-absorbing layer 130 to the electron transport layer 150, an energy level structure in the electron transport layer 150 decreases sequentially, improving the carrier transport capability in the electron transport layer 150, thereby increasing the current of the perovskite battery 100, resulting in a relatively high photoelectric energy conversion efficiency for the perovskite battery 100.

In some embodiments, along the direction from the perovskite light-absorbing layer 130 to the electron transport layer 150, a thickness ratio of at least two transport sub-layers 151 is (2 to 5):1. This allows for a relatively high carrier transport capability in the electron transport layer 150, resulting in a relatively high photoelectric energy conversion efficiency for the perovskite battery 100.

"Along the direction from the perovskite light-absorbing layer 130 to the electron transport layer 150, a thickness ratio of at least two transport sub-layers 151" means: the ratio of the thickness of the transport sub-layer 151 (denoted as a first sub-layer) that is close to the perovskite light-absorbing layer 130 in the at least two transport sub-layers 151 to a thickness of the transport sub-layer 151 that is adjacent to the aforementioned first sub-layer and located on the side away from the perovskite light-absorbing layer 130 in the at least two transport sub-layers 151.

For example, along the direction from the perovskite light-absorbing layer 130 to the electron transport layer 150, the thickness ratio of at least two transport sub-layers 151 may be any one point value of 2:1, 2.5:1, 3:1, 3.5:1, 4:1, 4.5:1, and 5:1, or a value within a range defined by any two thereof.

In some embodiments, along the direction from the perovskite light-absorbing layer 130 to the electron transport layer 150, the thicknesses of at least two transport sub-layers 151 are 13 nm to 30 nm and 5 nm to 15 nm, respectively. This allows for a relatively high carrier transport capability in the electron transport layer 150, resulting in a relatively high photoelectric energy conversion efficiency for the perovskite battery 100.

"Along the direction from the perovskite light-absorbing layer 130 to the electron transport layer 150, the thicknesses of at least two transport sub-layers 151 are 13 nm to 30 nm and 5 nm to 15 nm, respectively" means: the thickness of the transport sub-layer 151 (denoted as the first sub-layer) that is close to the perovskite light-absorbing layer 130 in the at least two transport sub-layers 151 is 13 nm to 30 nm, and the thickness of the transport sub-layer 151 that is adjacent to the aforementioned first sub-layer and located on the side away from the perovskite light-absorbing layer 130 in the at least two transport sub-layers 151 is 5 nm to 15 nm.

For example, the thickness of the transport sub-layer 151 (denoted as the first sub-layer) that is close to the perovskite light-absorbing layer 130 in the at least two transport sub-layers 151 may be any one point value of 13 nm, 13.3 nm, 15 nm, 17.5 nm, 20 nm, 22.5 nm, 25 nm, 27.5 nm, and 30 nm, or a value within a range defined by any two thereof; and the thickness of the transport sub-layer 151 that is adjacent to the aforementioned first sub-layer and located on the side away from the perovskite light-absorbing layer 130 in the at least two transport sub-layers 151 may be any one point value of 5 nm, 5.5 nm, 6 nm, 6.5 nm, 7 nm, 7.5 nm, 8 nm, 8.5 nm, 9 nm, 9.5 nm, 10 nm, 10.5 nm, 11 nm, 11.5 nm, 12 nm, 12.5 nm, 13 nm, 13.5 nm, 14 nm, 14.5 nm, and 15 nm, or a value within a range defined by any two thereof.

In some embodiments, the general formula of the metal oxide is MₓO_{y}, M representing a metal element, and y:x ≤ 0.5 × z, where z is the highest valence oxidation state of M.

The "highest valence oxidation state of M" means: the oxidation state corresponding to the situation when all valence electrons of the metal element represented by M are lost or transferred (electron pairs deviate from the atom) is the highest valence oxidation state.

The "×" in "0.5 × z" is a multiplication sign, and the value corresponding to "0.5 × z" is 0.5 times the value corresponding to "z". The "×" involved below are all multiplication signs.

In some embodiments, 0.4 × z ≤ y:x ≤ 0.5 × z. The ratio y:x of "y" to "x" in MₓO_{y} is within the above range, which is conducive to fully collecting electrons or holes generated by photon absorption in the perovskite light-absorbing layer 130 under illumination, thereby further improving the carrier transport capability in the electron transport layer 150, further enhancing the energy level matching between the electron transport layer 150 and the perovskite light-absorbing layer 130, and reducing the optical loss of the electron transport layer 150.

For example, the ratio y:x of "y" to "x" in MₓO_{y} may be any one point value of 0.4 × z, 0.42 × z, 0.425 × z, 0.43 × z, 0.44 × z, 0.45 × z, 0.46 × z, 0.47 × z, 0.48 × z, 0.49 × z, and 0.5 × z, or a value within a range defined by any two thereof.

In some embodiments, when the electron transport layer 150 has a transport sub-layer 151 where "y:x is 0.5 × z", the thickness proportion of the transport sub-layer 151 where y:x is 0.5 × z in the electron transport layer 150 is less than or equal to 75%.

It can be understood that, in other feasible embodiments, there may also be cases where the electron transport layer 150 does not have a transport sub-layer 151 where "y:x is 0.5 × z", that is, the y:x of the transport sub-layers 151 in the electron transport layer 150 are all less than 0.5 × z.

When the ratio of the number of metal atoms to the number of oxygen atoms in the metal oxide in one of the transport sub-layers 151 is 1:(0.5 × z) (where z is the highest valence oxidation state of the metal element), regulating the thickness proportion of the transport sub-layer 151 in the entire electron transport layer 150 to be less than or equal to 75% is conducive to further improving the carrier transport capability in the electron transport layer 150, thereby increasing the current of the perovskite battery 100, resulting in a relatively high photoelectric energy conversion efficiency for the perovskite battery 100.

For example, when the electron transport layer 150 has a transport sub-layer 151 where "y:x is 0.5 × z", the thickness proportion of the transport sub-layer 151 where y:x is 0.5 × z in the electron transport layer 150 may be any one point value of 1%, 5%, 10%, 15%, 20%, 25%, 30%, 35%, 40%, 45%, 50%, 55%, 60%, 65%, 70%, and 75%, or a value within a range defined by any two thereof.

In some embodiments, compared to all transport sub-layers 151 having y:x less than 0.5 × z, when y:x of one transport sub-layer 151 is 0.5 × z, it is conducive to further improving the carrier transport capability in the electron transport layer 150, thereby increasing the current of the perovskite battery 100, resulting in a relatively high photoelectric energy conversion efficiency for the perovskite battery 100.

In some embodiments, a metal element in the metal oxide includes at least one of Sn, Ti, Zn, W, Nb, In, Zr, Ce, Cr, Ba, Sr, Fe, and Li. This can effectively block the migration of ions, facilitating avoiding film degradation or deterioration caused by ion migration in the perovskite battery 100, and facilitating prolonging the service life of the perovskite battery 100.

In some embodiments, the metal element in the metal oxide includes at least one of Zn, Ti, and Sn.

In some embodiments, when the metal element in the metal oxide includes Sn, the highest valence oxidation state of Sn is 4, and the ratio y:x of "y" to "x" in the corresponding SnₓO_{y} is less than or equal to 2 (that is, 0.5 × 4); further, the ratio of "y" to "x" in SnₓO_{y} satisfies: 1.7 ≤ y:x ≤ 2.

For example, when the metal element in the metal oxide includes Sn, and the ratio y:x of "y" to "x" in the metal oxide SnₓO_{y} in each transport sub-layer 151 may be any one point value of 2, 1.9, 1.8, 1.7, 1.6, and 1.5, or a value within a range defined by any two thereof. For example, the metal oxide SnₓO_{y} in each transport sub-layer 151 may be SnO₂, SnO_{1.9}, SnO_{1.8}, SnO_{1.7}, SnO_{1.6}, or the like.

In some embodiments, in addition to the metal oxide, the transport sub-layer 151 may also have other electron transport materials, and the other electron transport materials include, for example, at least one of the following materials, derivatives thereof, and materials obtained by doping or passivation thereof: an imine compound, a quinone compound, fullerene and a derivative thereof, silicon oxide, strontium titanate, calcium titanate, lithium fluoride, and calcium fluoride. For example, the other electron transport materials may be selected from [6,6]-phenyl-C61-butyric acid methyl ester (PC61BM), [6,6]-phenyl-C71-butyric acid methyl ester (PC71BM), fullerene C₆₀, fullerene C₆₁, fullerene C₇₀, bathocuproine, or the like.

For example, the thickness of the electron transport layer 150 may be, for example, 5 nm □ 200 nm, and optionally 20 nm □ 50 nm.

In some embodiments, along the direction from the perovskite light-absorbing layer 130 to the electron transport layer 150, energy levels of the transport sub-layer 151 decrease sequentially. The above arrangement can improve the carrier transport capability in the electron transport layer 150, thereby increasing the current of the perovskite battery 100, resulting in a relatively high photoelectric energy conversion efficiency for the perovskite battery 100.

In some embodiments, an energy level difference between two adjacent transport sub-layers 151 is less than or equal to 0.2 eV, which is conducive to improving the carrier extraction efficiency, thereby improving the photoelectric energy conversion efficiency of the perovskite battery 100.

For example, the energy level difference between two adjacent transport sub-layers 151 may be any one point value of 0.01 eV, 0.02 eV, 0.05 eV, 0.07 eV, 0.1 eV, 0.12 eV, 0.15 eV, 0.17 eV, and 0.2 eV, or a value within a range defined by any two thereof.

In some embodiments, an intermediate layer 140 is disposed between the perovskite light-absorbing layer 130 and the electron transport layer 150; and the material of the intermediate layer 140 includes a conductive material containing a carbon element.

The "conductive material containing a carbon element" means: the material contains carbon atoms, and the material has the ability to extract or migrate electrons.

Since the perovskite light-absorbing layer 130 is a polycrystalline thin film, its surface inevitably contains a relatively large number of defects, mainly including uncoordinated ions and grain boundaries and dangling bonds on crystal surfaces. The defects on the surface of the perovskite light-absorbing layer 130 may cause the perovskite battery 100 to exhibit a hysteresis effect.

The hysteresis effect refers to a certain lag relationship between the output current and the input light intensity of the perovskite battery 100. Specifically, when the light intensity changes from low to high, the output current of the perovskite battery 100 does not follow the change immediately, but has a certain delay. This phenomenon leads to a certain nonlinear relationship between the output current and the input light intensity of the perovskite battery 100, thereby affecting the performance and efficiency of the solar cell.

The present application, by arranging an intermediate layer 140 between the perovskite light-absorbing layer 130 and the electron transport layer 150, can passivate the defects on a surface of the perovskite light-absorbing layer 130, improve the interface energy level matching degree between the perovskite light-absorbing layer 130 and the electron transport layer 150 in the perovskite battery 100 (especially the inverted-structure perovskite battery 100), which is conducive to avoiding the hysteresis effect in the perovskite battery 100, improving the carrier transport capability, and improving the photoelectric energy conversion efficiency of the perovskite battery 100.

In some embodiments, the material of the intermediate layer 140 includes at least one of fullerene and a derivative thereof, an imide compound, a quinone compound, a pyrrolidone compound, an isoindigo compound, an indigo compound, a benzobisthiadiazole compound, a hexaazanaphthalenes compound, an indenothiophene compound, a tetraphenylethylene compound, and a conjugated polymer. Wherein, the conjugated polymer includes at least one of PFN-2TNDI, PBDT-PDI, NDP-V, P(NDI2DT-TTCN), PN-F, and PF-PDI.

The material of the intermediate layer 140 includes the above substances, which is conducive to avoiding the hysteresis effect in the perovskite battery 100, thereby improving the photoelectric energy conversion efficiency of the perovskite battery 100.

In some embodiments, an energy level M₁ of the intermediate layer 140 is less than an energy level M₂ of the transport sub-layer 151 adjacent to the intermediate layer 140, and M₂ - M₁ ≤ 0.2 eV. The above arrangement can improve the interface energy level matching degree between the perovskite light-absorbing layer 130 and the electron transport layer 150 in the perovskite battery 100 (especially the inverted-structure perovskite battery 100), which is conducive to avoiding the hysteresis effect in the perovskite battery 100, improving the carrier transport capability, and improving the photoelectric energy conversion efficiency of the perovskite battery 100.

For example, M₂ - M₁ may be any one point value of 0.01 eV, 0.02 eV, 0.05 eV, 0.07 eV, 0.1 eV, 0.12 eV, 0.15 eV, 0.17 eV, and 0.2 eV, or a value within a range defined by any two thereof.

In some embodiments, a thickness ratio of the intermediate layer 140 to the electron transport layer 150 is (0.01 to 50):1, resulting in a relatively high photoelectric energy conversion efficiency for the perovskite battery.

The "thickness ratio of the intermediate layer 140 to the electron transport layer 150" means: the ratio of a thickness of the intermediate layer 140 to a thickness of the entire electron transport layer 150.

For example, the thickness ratio of the intermediate layer 140 to the electron transport layer 150 may be any one point value of 0.01:1, 1:1, 5:1, 10:1, 20:1, 30:1, 40:1, and 50:1, or a value within a range defined by any two thereof.

In some embodiments, the thickness ratio of the intermediate layer 140 to the electron transport layer 150 is (1 to 3):1.

The thickness ratio of the intermediate layer 140 to the electron transport layer 150 is (1 to 3):1, which can fully exert the advantages of the intermediate layer 140 and the electron transport layer 150, facilitating further improving the photoelectric energy conversion efficiency of the perovskite battery 100.

For example, the thickness ratio of the intermediate layer 140 to the electron transport layer 150 may be any one point value of 1:1, 1.2:1, 1.5:1, 1.7:1, 2:1, 2.2:1, 2.5:1, 2.7:1, and 3:1, or a value within a range defined by any two thereof.

For example, the thickness of the intermediate layer 140 may be, for example, 5 nm to 100 nm.

Based on the above embodiments, an exemplary preparation process of the inverted-structure perovskite battery 100 includes:
Step 1: Clean a transparent substrate layer 110 and blow dry for later use.
Step 2: Prepare a hole transport layer 120 on the transparent substrate layer 110 for later use.
Step 3: Prepare a perovskite light-absorbing layer 130 on the hole transport layer 120 for later use.
Step 4: Prepare an intermediate layer 140 on the perovskite light-absorbing layer 130 for later use.
Step 5: Prepare an electron transport layer 150 (including at least two transport sub-layers 151) on the intermediate layer 140 for later use.
Step 6: Prepare an electrode layer 160 on the electron transport layer 150, and perform edge cleaning and testing.

In some embodiments, the preparation of the intermediate layer 140 may also be omitted, and the electron transport layer 150 is directly prepared on the perovskite light-absorbing layer 130.

An exemplary preparation process of the regular-structure perovskite battery 100 includes:
Step 1: Clean a transparent substrate layer 110 and blow dry for later use.
Step 2: Prepare an electron transport layer 150 (including at least two transport sub-layers 151) on the transparent substrate layer 110 for later use.
Step 3: Prepare an intermediate layer 140 on the electron transport layer 150 for later use.
Step 4: Prepare a perovskite light-absorbing layer 130 on the intermediate layer 140 for later use.
Step 5: Prepare a hole transport layer 120 on the perovskite light-absorbing layer 130 for later use.
Step 6: Prepare an electrode layer 160 on the hole transport layer 120, and perform edge cleaning and testing.

In some embodiments, the preparation of the intermediate layer 140 may also be omitted, and the perovskite light-absorbing layer 130 is directly prepared on the electron transport layer 150.

In this embodiment, the transparent substrate layer 110, the hole transport layer 120, the perovskite light-absorbing layer 130, the intermediate layer 140, the electron transport layer 150, and the electrode layer 160 are arranged in a suitable order, facilitating the formation of each layer structure and making the process convenient.

It can be understood that the preparation methods of the above layers include but are not limited to any one of chemical bath deposition method, electrochemical deposition method, chemical vapor deposition method, physical epitaxial growth method, thermal co-evaporation method, atomic layer deposition method, magnetron sputtering method, precursor solution coating method, precursor solution slot-die coating method, and precursor solution scraping method. Those skilled in the art may select according to actual needs. In addition to the above methods, mechanical pressing method may also be used to form at least two interconnected functional layers at one time.

Optionally, the preparation method of each layer is thermal evaporation method or precursor solution coating method, where the precursor solution coating method may be spin coating.

For example, the method of the inverted-structure perovskite battery 100 includes: The hole transport layer 120 is deposited on a surface of the transparent substrate by magnetron sputtering method; a perovskite light-absorbing layer 130 slurry is spin-coated on a surface of the hole transport layer 120 at a rotation speed of 3000 rpm to 4500 rpm, followed by drying on a constant-temperature hot plate at, for example, 100°C to 200°C, to obtain the perovskite light-absorbing layer 130; then vacuum evaporation method is used, in a vacuum thermal evaporation equipment, under a vacuum condition of 4 × 10^{□4} Pa, the intermediate layer 140 is deposited on a surface of the perovskite light-absorbing layer 130; atomic deposition method is used to deposit the electron transport layer 150 (including at least two transport sub-layers 151) on a surface of the intermediate layer 140; and in a vacuum coating machine, under a vacuum condition of 5 × 10^{□4} Pa, the electrode layer 160 is evaporated on the surface of the electron transport layer 150.

For example, the method of the regular-structure perovskite battery 100 includes: Atomic deposition method is used to deposit the electron transport layer 150 (including at least two transport sub-layers 151) on a surface of the transparent substrate; then vacuum evaporation method is used, in a vacuum thermal evaporation equipment, under a vacuum condition of 4 × 10^{□4} Pa, the intermediate layer 140 is deposited on a surface of the electron transport layer 150; a perovskite light-absorbing layer 130 slurry is spin-coated on a surface of the intermediate layer 140 at a rotation speed of 3000 rpm to 4500 rpm, followed by drying on a constant-temperature hot plate at, for example, 100°C to 200°C, to obtain the perovskite light-absorbing layer 130; magnetron sputtering method is used to deposit the hole transport layer 120 on a surface of the perovskite light-absorbing layer 130; and in a vacuum coating machine, under a vacuum condition of 5 × 10^{□4} Pa, the electrode layer 160 is evaporated on a surface of the hole transport layer 120.

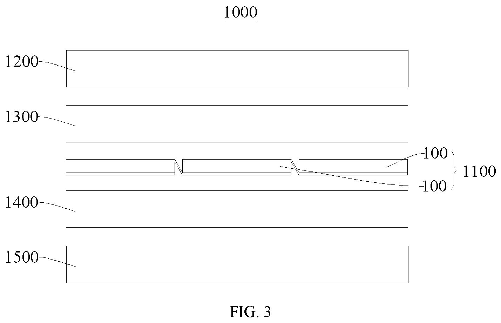

According to some embodiments of the present application, the present application further provides a tandem solar cell, including the perovskite battery 100 as provided in any of the above solutions. Referring to FIG. 3, according to some embodiments of the present application, the present application further provides a photovoltaic module 1000, including the perovskite battery 100 as provided in any of the above solutions.

The photovoltaic module 1000 refers to a solar cell module, that is, an overall module including a plurality of perovskite batteries 100, including a plurality of battery strings 1100, where each battery string 1100 includes a plurality of perovskite batteries 100 connected in series through connectors such as welding ribbons. "A plurality of" means an integer number of one, two, or more.

In the photovoltaic module 1000, in addition to the battery string 1100, it may also include a front glass 1200, a front encapsulation film 1300, a back encapsulation film 1400, a back glass 1500, or the like. As an example, the photovoltaic module 1000 includes the front glass 1200, the front encapsulation film 1300, the battery string 1100, the back encapsulation film 1400, and the back glass 1500 that are sequentially stacked along the thickness direction.

According to some embodiments of the present application, the present application further provides a photovoltaic module 1000, including the tandem solar cell provided above.

According to some embodiments of the present application, the present application further provides a photovoltaic power generation system, including a plurality of electrically connected photovoltaic modules 1000.

"A plurality of" means an integer number of one, two, or more.

The photovoltaic power generation system refers to a power generation system that directly converts solar radiation energy into electrical energy using the photovoltaic effect, and is divided into a standalone photovoltaic power generation system (Stand□alone PV System) and a grid-connected photovoltaic power generation system (Grid□connected PV System). The standalone photovoltaic power generation system consists of a solar photovoltaic array composed of photovoltaic modules 1000, a battery pack, a charge controller, a power electronic converter (inverter), a load, and the like. The grid-connected photovoltaic power generation system consists of a photovoltaic array, a high-frequency DC/DC boost circuit, a power electronic converter (inverter), and a system monitoring part.

According to some embodiments of the present application, the present application further provides an electric device, including the photovoltaic power generation system provided in the above solutions, where the photovoltaic power generation system is configured to provide electrical energy to the electric device.

The electric device may be in various forms, such as an electric vehicle, a ship, a spacecraft, a solar water heater, and solar energy.

The power supply method of the electric device can be single power supply by the photovoltaic module 1000, or cooperative power supply by the photovoltaic module 1000 and an energy storage battery, that is, the electric device is equipped with both the photovoltaic module 1000 and the energy storage battery. The energy storage battery is not limited to primary batteries and secondary batteries, for example but not limited to lithium-ion secondary batteries, sodium-ion secondary batteries, etc.

Next, one or more embodiments are described in more detail with reference to the following examples. Certainly, these examples do not limit the scope of one or more embodiments.

### Example 1

The preparation method of the perovskite battery 100 as shown in FIG. 1 included:

### (1) Preparation of transparent substrate layer 110:

A surface of an FTO conductive glass with a size of 2.0 cm × 2.0 cm was sequentially cleaned with acetone and isopropanol twice, immersed in deionized water for ultrasonic treatment for 10 min, dried in a blast drying oven, and then placed in a glove box (N₂ atmosphere) to serve as the transparent substrate layer 110.

### (2) Preparation of hole transport layer 120:

Nickel oxide was deposited on the surface of the conductive glass using a magnetron sputtering method to form the hole transport layer 120 with a thickness of 15 nm.

### (3) Preparation of perovskite light-absorbing layer 130:

A mixed DMF solution of 5 mg/mL CuInP₂S₆ nano-colloid and 1.5 mol/L FAPbI₃ was spin-coated on the obtained hole transport layer 120 at 4000 rpm, then transferred to a constant-temperature hot plate and heated at 100°C for 30 min, and cooled to room temperature to form the perovskite light-absorbing layer 130 with a thickness of 500 nm.

### Preparation of intermediate layer 140:

The device prepared above was placed into a vacuum thermal evaporation equipment, evacuated to 4 × 10⁻⁴ Pa, and a 30 nm intermediate layer 140 made of C₆₀ was deposited on the surface of the perovskite light-absorbing layer 130.

### (5) Preparation of electron transport layer 150:

Two layers of transport sub-layers 151 made of tin oxide were sequentially deposited on the surface of the intermediate layer 140 using an atomic layer deposition method, and a ratio of tin atoms to oxygen atoms Sn/O in the tin oxide in the two transport sub-layers 151 was sequentially 1:2.0 and 1:1.7, and the thicknesses of the two transport sub-layers 151 were 20 nm and 10 nm, respectively.

### (6) Preparation of electrode layer 160:

The device prepared above was placed into a vacuum coating machine, and under a vacuum condition of 5 × 10⁻⁴ Pa, a Cu electrode was evaporated on the surface of the electron transport layer 150 at an evaporation rate of 0.1 Å/s to form the electrode layer 160 with a thickness of 80 nm.

### Example 2

The preparation method of the perovskite battery 100 as shown in FIG. 2 included:

### (1) Preparation of transparent substrate layer 110:

A surface of FTO conductive glass with a size of 2.0 cm × 2.0 cm was sequentially cleaned with acetone and isopropanol twice, immersed in deionized water for ultrasonic treatment for 10 min, dried in a blast drying oven, and then placed in a glove box (N₂ atmosphere) to serve as the transparent substrate layer 110.

### (2) Preparation of electron transport layer 150:

Two layers of transport sub-layers 151 made of tin oxide were sequentially deposited on the surface of the transparent substrate layer 110 using an atomic layer deposition method, and a ratio of tin atoms to oxygen atoms Sn/O in the tin oxide in the two transport sub-layers 151 was sequentially 1:1.7 and 1:2.0, and the thicknesses of the two transport sub-layers 151 were 10 nm and 20 nm, respectively.

### (3) Preparation of intermediate layer 140:

The device prepared above was placed into a vacuum thermal evaporation equipment, evacuated to 4 × 10⁻⁴ Pa, and a 30 nm intermediate layer 140 made of C₆₀ was deposited on the surface of the electron transport layer 150.

### (4) Preparation of perovskite light-absorbing layer 130:

A mixed DMF solution of 5 mg/mL CuInP₂S₆ nano-colloid and 1.5 mol/L FAPbI₃ was spin-coated on the obtained intermediate layer 140 at 4000 rpm, then transferred to a constant-temperature hot plate and heated at 100°C for 30 min, and cooled to room temperature to form the perovskite light-absorbing layer 130 with a thickness of 500 nm.

### (5) Preparation of hole transport layer 120:

A chlorobenzene solution of 73 mg/mL Spiro-OMeTAD was spin-coated on the surface of the perovskite light-absorbing layer 130 at 3000 rpm using a magnetron sputtering method to form the hole transport layer 120 with a thickness of 30 nm.

### (6) Preparation of electrode layer 160:

The device prepared above was placed into a vacuum coating machine, and under a vacuum condition of 5 × 10⁻⁴ Pa, a Cu electrode was evaporated on the surface of the hole transport layer 120 at an evaporation rate of 0.1 Å/s to form the electrode layer 160 with a thickness of 80 nm.

### Examples 3 to 26 and Comparative Examples 1 to 8

The differences of Examples 3 to 14 and Comparative Examples 1 to 4 from Example 1 are shown in Table 1 and Table 2, and the differences of Examples 15 to 26 and Comparative Examples 5 to 8 from Example 2 are shown in Table 1 and Table 2.

**Table 1 Parameters of Electron Transport Layer of Perovskite Batteries**

| | Material of first transport sub-layer | Thickness of first transport sub-layer (nm) | Material of second transport sub-layer | Thickness of second transport sub-layer (nm) | Material of third transport sub-layer | Thickness of third transport sub-layer (nm) |
|---|---|---|---|---|---|---|
| Example 1 | SnO₂ | 20 | SnO_{1.7} | 10 | / | / |
| Example 3 | SnO_{1.9} | 20 | SnO_{1.7} | 10 | / | / |
| Example 4 | SnO₂ | 20 | SnO_{1.6} | 10 | / | / |
| Example 5 | SnO₂ | 20 | SnO_{1.5} | 10 | / | / |
| Example 6 | SnO₂ | 22.5 | SnO_{1.7} | 7.5 | / | / |
| Example 7 | SnO₂ | 25 | SnO_{1.7} | 5 | / | / |
| Example 8 | SnO₂ | 20 | SnO_{1.9} | 6 | SnO_{1.7} | 4 |
| Example 9 | TiO₂ | 20 | TiO_{1.7} | 10 | / | / |
| Example 10 | SnO₂ | 30 | SnO_{1.7} | 15 | / | / |
| Example 11 | SnO₂ | 15 | SnO_{1.7} | 7.5 | / | / |
| Example 12 | SnO₂ | 15 | SnO_{1.7} | 7.5 | / | / |
| Example 13 | SnO₂ | 20 | SnO_{1.7} | 10 | / | / |
| Example 14 | SnO₂ | 20 | SnO_{1.7} | 10 | / | / |
| Comparative Example 1 | SnO₂ | 30 | / | / | / | / |
| Comparative Example 2 | SnO₂ and SnO_{1.7} with a mass ratio of 2:1 | 30 | / | / | / | / |
| Comparative Example 3 | TiO₂ | 30 | / | / | / | / |
| Comparative Example 4 | TiO₂ and TiO_{1.7} with a mass ratio of 2:1 | 30 | / | / | / | / |
| Example 2 | SnO₂ | 20 | SnO_{1.7} | 10 | / | / |
| Example 15 | SnO_{1.9} | 20 | SnO_{1.7} | 10 | / | / |
| Example 16 | SnO₂ | 20 | SnO_{1.6} | 10 | / | / |
| Example 17 | SnO₂ | 20 | SnO_{1.5} | 10 | / | / |
| Example 18 | SnO₂ | 22.5 | SnO_{1.7} | 7.5 | / | / |
| Example 19 | SnO₂ | 25 | SnO_{1.7} | 5 | / | / |
| Example 20 | SnO₂ | 20 | SnO_{1.9} | 6 | SnO_{1.7} | 4 |
| Example 21 | TiO₂ | 20 | TiO_{1.7} | 10 | / | / |
| Example 22 | SnO₂ | 30 | SnO_{1.7} | 15 | / | / |
| Example 23 | SnO₂ | 15 | SnO_{1.7} | 7.5 | / | / |
| Example 24 | SnO₂ | 15 | SnO_{1.7} | 7.5 | / | / |
| Example 25 | SnO₂ | 20 | SnO_{1.7} | 10 | / | / |
| Example 26 | SnO₂ | 20 | SnO_{1.7} | 10 | / | / |
| Comparative Example 5 | SnO₂ | 30 | / | / | / | / |
| Comparative Example 6 | SnO₂ and SnO_{1.7} with a mass ratio of 2:1 | 30 | / | / | / | / |
| Comparative Example 7 | TiO₂ | 30 | / | / | / | / |
| Comparative Example 8 | TiO₂ and TiO_{1.7} with a mass ratio of 2:1 | 30 | / | / | / | / |

In Table 1, "/" means that a corresponding parameter does not exist, and "SnO₂ and SnO_{1.7} with a mass ratio of 2:1" in Comparative Example 2 and Comparative Example 6 means: the transport sub-layer is composed of a mixture of SnO₂ and SnO_{1.7} with a mass ratio of 2:1, and "TiO₂ and TiO_{1.7} with a mass ratio of 2:1" in Comparative Example 4 and Comparative Example 8 means: the transport sub-layer is composed of a mixture of TiO₂ and TiO_{1.7} with a mass ratio of 2:1.

**Table 2 Parameters of Perovskite Batteries**

| | Total thickness of electron transport layer (nm) | Material of intermediate layer | Thickness of intermediate layer (nm) | Thickness ratio of intermediate layer to electron transport layer | Type of perovskite battery |
|---|---|---|---|---|---|
| Example 1 | 30 | C₆₀ | 60 | 2:1 | Inverted-structure perovskite battery |
| Example 3 | 30 | C₆₀ | 60 | 2:1 | |
| Example 4 | 30 | C₆₀ | 60 | 2:1 | |
| Example 5 | 30 | C₆₀ | 60 | 2:1 | |
| Example 6 | 30 | C₆₀ | 60 | 2:1 | |
| Example 7 | 30 | C₆₀ | 60 | 2:1 | |
| Example 8 | 30 | C₆₀ | 60 | 2:1 | |
| Example 9 | 30 | C₆₀ | 60 | 2:1 | |
| Example 10 | 45 | C₆₀ | 45 | 1:1 | |
| Example 11 | 22.5 | C₆₀ | 67.5 | 3:1 | |
| Example 12 | 22.5 | C₆₀ | 78.75 | 3.5:1 | |
| Example 13 | 30 | PCBM | 60 | 2:1 | |
| Example 14 | 30 | / | / | / | |
| Comparative Example 1 | 30 | / | / | / | |
| Comparative Example 2 | 30 | / | / | / | |
| Comparative Example 3 | 30 | / | / | / | |
| Comparative Example 4 | 30 | / | / | / | |
| Example 2 | 30 | C₆₀ | 60 | 2:1 | Regular-structure perovskite battery |
| Example 15 | 30 | C₆₀ | 60 | 2:1 | |
| Example 16 | 30 | C₆₀ | 60 | 2:1 | |
| Example 17 | 30 | C₆₀ | 60 | 2:1 | |
| Example 18 | 30 | C₆₀ | 60 | 2:1 | |
| Example 19 | 30 | C₆₀ | 60 | 2:1 | |
| Example 20 | 30 | C₆₀ | 60 | 2:1 | |
| Example 21 | 30 | C₆₀ | 60 | 2:1 | |
| Example 22 | 45 | C₆₀ | 45 | 1:1 | |
| Example 23 | 22.5 | C₆₀ | 67.5 | 3:1 | |
| Example 24 | 22.5 | C₆₀ | 78.75 | 3.5:1 | |
| Example 25 | 30 | PCBM | 60 | 2:1 | |
| Example 26 | 30 | / | / | / | |
| Comparative Example 5 | 30 | / | / | / | |
| Comparative Example 6 | 30 | / | / | / | |
| Comparative Example 7 | 30 | / | / | / | |
| Comparative Example 8 | 30 | / | / | / | |

In Table 2, PCBM refers to [6,6]-phenyl-C61-butyric acid methyl ester, and "/" means that a corresponding parameter does not exist.

The energy conversion efficiency of the perovskite batteries prepared in Examples 1 to 26 and Comparative Examples 1 to 8 was measured. The results are shown in Table 3. The test conditions for the energy conversion efficiency are as follows:

Under atmospheric conditions, a solar simulator with an AM1.5G standard light source was used, and a four-channel digital source meter (Keithley 2440) was used to measure the current-voltage characteristic curve of the battery under light irradiation, to obtain a battery operating output power Pout (in units of mW/cm²) of the perovskite battery. The energy conversion efficiency Eff (Efficiency) of the battery was then calculated. For the AM1.5G standard light source, the incident light power Popt was 100 mW/cm².

The energy conversion efficiency was calculated as follows: Eff = (Pout / Popt) × 100%.

**Table 3 Test Results of Perovskite Batteries 100**

| | Operating output power Pout (mW/cm²) | Energy conversion efficiency Eff (%) | | Operating output power Pout (mW/cm²) | Energy conversion efficiency Eff (%) |
|---|---|---|---|---|---|
| Example 1 | 22.5 | 22.5 | Example 2 | 22.4 | 22.4 |
| Example 3 | 22.3 | 22.3 | Example 15 | 22.2 | 22.2 |
| Example 4 | 21.8 | 21.8 | Example 16 | 21.6 | 21.6 |
| Example 5 | 21.3 | 21.3 | Example 17 | 21.2 | 21.2 |
| Example 6 | 22.3 | 22.3 | Example 18 | 22.1 | 22.1 |
| Example 7 | 22.2 | 22.2 | Example 19 | 22 | 22 |
| Example 8 | 22.1 | 22.1 | Example 20 | 21.9 | 21.9 |
| Example 9 | 21 | 21 | Example 21 | 21 | 21 |
| Example 10 | 21.9 | 21.9 | Example 22 | 21.8 | 21.8 |
| Example 11 | 21.7 | 21.7 | Example 23 | 21.6 | 21.6 |
| Example 12 | 22 | 21.6 | Example 24 | 21.9 | 21.5 |
| Example 13 | 22.3 | 22.3 | Example 25 | 22.1 | 22.1 |
| Example 14 | 20.6 | 20.6 | Example 26 | 20.5 | 20.5 |
| Comparative Example 1 | 16.6 | 16.6 | Comparative Example 5 | 16.5 | 16.5 |
| Comparative Example 2 | 17 | 17 | Comparative Example 6 | 16.8 | 16.8 |
| Comparative Example 3 | 15 | 15 | Comparative Example 7 | 15 | 15 |
| Comparative Example 4 | 15.3 | 15.3 | Comparative Example 8 | 15.2 | 15.2 |

It can be learned from Table 3 that the energy conversion efficiency of the inverted-structure perovskite batteries prepared in Example 1 and Examples 3 to 14 is higher than the energy conversion efficiency of the inverted-structure perovskite batteries prepared in Comparative Examples 1 to 4, and the energy conversion efficiency of the regular-structure perovskite batteries prepared in Example 2 and Examples 15 to 26 is higher than the energy conversion efficiency of the regular-structure perovskite batteries prepared in Comparative Examples 5 to 8. This indicates that, along the direction from the perovskite light-absorbing layer to the electron transport layer, setting the ratio of the number of metal atoms to the number of oxygen atoms in the metal oxide in the transport sub-layers to increase sequentially can improve the photoelectric energy conversion efficiency of the perovskite battery.

It can be learned from the comparison between Example 1 and Example 3, and between Example 2 and Example 15 that, when the ratio of metal atoms to oxygen atoms in the second transport sub-layer is the same, compared to the case where the atomic ratio y/x of oxygen atoms to metal atoms in the first transport sub-layer is less than 0.5 × z (where z is the highest valence oxidation state of the metal atom), when the atomic ratio y/x of oxygen atoms to metal atoms in the first transport sub-layer is 0.5 × z (where z is the highest valence oxidation state of the metal atom), the energy conversion efficiency of the perovskite battery can be further improved.

It can be learned from the comparison between Example 1 and Examples 4 to 5, and between Example 2 and Examples 16 to 17 that, when the atomic ratio y/x of oxygen atoms to tin atoms in the transport sub-layer satisfies 1.7 ≤ y:x ≤ 2, it is conducive to further improving the energy conversion efficiency of the perovskite battery.

It can be learned from the comparison between Example 1 and Examples 6 to 7, and between Example 2 and Examples 18 to 19 that, when the atomic ratio y/x of oxygen atoms to metal atoms in the first transport sub-layer is 0.5 × z (where z is the highest valence oxidation state of the metal atom), and the proportion of the thickness of the first transport sub-layer to the total thickness of the electron transport layer is less than or equal to 75%, it is conducive to further improving the energy conversion efficiency of the perovskite battery.

It can be learned from the comparison between Example 1 and Example 8, and between Example 2 and Example 20 that, when "the electron transport layer has at least two transport sub-layers (two or three layers), and along the direction from the perovskite light-absorbing layer to the electron transport layer, the ratio of the number of metal atoms to the number of oxygen atoms in the metal oxide in the transport sub-layers is set to increase sequentially", the energy conversion efficiency of the perovskite battery can be effectively improved in both cases.

It can be learned from the comparison between Example 1 and Example 9, and between Example 2 and Example 21 that, when the material of the electron transport layer is tin oxide or titanium oxide, the energy conversion efficiency of the perovskite battery can be effectively improved in both cases.

It can be learned from the comparison between Example 1 and Examples 10 to 12, and between Example 2 and Examples 22 to 24 that the thickness ratio of the electron transport layer to the intermediate layer can further affect the energy conversion efficiency of the perovskite battery. When the thickness ratio of the electron transport layer to the intermediate layer is 1:(1 to 3), it is conducive to further improving the energy conversion efficiency of the perovskite battery.

It can be learned from the comparison between Example 1 and Example 13, and between Example 2 and Example 25 that, when the material of the intermediate layer is C₆₀ or PCBM (that is, [6,6]-phenyl-C61-butyric acid methyl ester), the energy conversion efficiency of the perovskite battery can be effectively improved in both cases.

It can be learned from the comparison between Example 1 and Example 14, and between Example 2 and Example 26 that, when no intermediate layer is provided in the perovskite battery, along the direction from the perovskite light-absorbing layer to the electron transport layer, setting the ratio of the number of metal atoms to the number of oxygen atoms in the metal oxide in the transport sub-layers to increase sequentially can still effectively improve the energy conversion efficiency of the perovskite battery.

In conclusion, it should be noted that the foregoing embodiments are merely for describing the technical solutions of the present application rather than for limiting the present application. Although the present application has been described in detail with reference to the foregoing embodiments, persons of ordinary skill in the art should appreciate that they can still make modifications to the technical solutions described in the embodiments or make equivalent replacements to some or all technical features thereof without departing from the scope of the technical solutions of the embodiments of the present application. All such modifications and equivalent replacements shall fall within the scope of claims and specification of the present application. In particular, as long as there is no structural conflict, the various technical features mentioned in the embodiments can be combined in any manner. The present application is not limited to the specific embodiments disclosed in this specification, but includes all technical solutions falling within the scope of the claims.

## Claims

1. A perovskite battery, wherein the perovskite battery comprises a perovskite light-absorbing layer and an electron transport layer, and the electron transport layer comprises at least two transport sub-layers; and
the material of the transport sub-layer comprises a metal oxide MₓO_{y}, M representing a metal element; and an atomic ratio of metal atoms to oxygen atoms in the transport sub-layer is x/y, and along a direction from the perovskite light-absorbing layer to the electron transport layer, the values of x/y of the transport sub-layers increase sequentially.

2. The perovskite battery according to claim 1, wherein along the direction from the perovskite light-absorbing layer to the electron transport layer, a thickness ratio of at least two transport sub-layers is (2 to 5):1.

3. The perovskite battery according to claim 2, wherein along the direction from the perovskite light-absorbing layer to the electron transport layer, thicknesses of at least two transport sub-layers are 13 nm to 30 nm and 5 nm to 15 nm, respectively.

4. The perovskite battery according to claim 1, wherein y:x ≤ 0.5 × z, z being the highest valence oxidation state of the M.

5. The perovskite battery according to claim 4, wherein 0.4 × z ≤ y:x ≤ 0.5 × z.

6. The perovskite battery according to claim 4, wherein, when y:x in one transport sub-layer is 0.5 × z, the thickness proportion of the transport sub-layer where y:x is 0.5 × z in the electron transport layer is less than or equal to 75%.

7. The perovskite battery according to claim 1, wherein a metal element in the metal oxide comprises at least one of Sn, Ti, Zn, W, Nb, In, Zr, Ce, Cr, Ba, Sr, Fe, and Li; and
optionally, the metal element in the metal oxide comprises at least one of Zn, Ti, and Sn.

8. The perovskite battery according to claim 1, wherein along the direction from the perovskite light-absorbing layer to the electron transport layer, energy levels of the transport sub-layers decrease sequentially.

9. The perovskite battery according to claim 8, wherein an energy level difference between two adjacent transport sub-layers is less than or equal to 0.2 eV.

10. The perovskite battery according to any one of claims 1 to 9, wherein an intermediate layer is disposed between the perovskite light-absorbing layer and the electron transport layer; the material of the intermediate layer comprises a conductive material containing a carbon element; and
optionally, the material of the intermediate layer comprises at least one of fullerene and a derivative thereof, an imide compound, a quinone compound, a pyrrolidone compound, an isoindigo compound, an indigo compound, a benzobisthiadiazole compound, a hexaazanaphthalenes compound, an indenothiophene compound, a tetraphenylethylene compound, and a conjugated polymer.

11. The perovskite battery according to claim 10, wherein an energy level M₁ of the intermediate layer is less than an energy level M₂ of the transport sub-layer adjacent to the intermediate layer, and M₂ - M₁ ≤ 0.2 eV.

12. The perovskite battery according to claim 10, wherein a thickness ratio of the intermediate layer to the electron transport layer is (0.01 to 50):1; and
optionally, the thickness ratio of the intermediate layer to the electron transport layer is (1 to 3):1.

13. The perovskite battery according to claim 10, wherein the perovskite battery comprises a transparent substrate layer, a hole transport layer, the perovskite light-absorbing layer, the intermediate layer, the electron transport layer, and an electrode layer sequentially provided;
or, the perovskite battery comprises a transparent substrate layer, the electron transport layer, the intermediate layer, the perovskite light-absorbing layer, a hole transport layer, and an electrode layer sequentially provided.

14. A tandem solar cell, wherein the tandem solar cell comprises the perovskite battery according to any one of claims 1 to 13.

15. A photovoltaic module, wherein the photovoltaic module comprises the perovskite battery according to any one of claims 1 to 13 or the tandem solar cell according to claim 14.

16. A photovoltaic power generation system, wherein the photovoltaic power generation system comprises a plurality of electrically connected photovoltaic modules according to claim 15.

17. An electric device, wherein the electric device comprises a plurality of electrically connected photovoltaic power generation systems according to claim 16.
